# EUROPÄISCHE PATENTANMELDUNG

(11) **EP 3 674 841 A1**
(43) Veröffentlichungstag der Anmeldung: **01.07.2020**
(21) Anmeldenummer: 18215836.0
(22) Anmeldetag: 24.12.2018
(51) Int. Cl.: G06F 1/20, G02F 1/1333, H05K 7/20, G06F 1/16

(54) **ANZEIGEVORRICHTUNG**

(71) Anmelder: SKIDATA AG, 5083 Grödig/Salzburg (AT)
(72) Erfinder: Kranzinger, Erich, 5083 Grödig/Salzburg (AT); Reichartzeder, Simon, 5083 Grödig/Salzburg (AT)
(74) Vertreter: Karakatsanis, Georgios

(57) **Zusammenfassung**

Es wird eine Anzeigevorrichtung vorgeschlagen, umfassend ein Display (2) mit elektronischen Komponenten, vor dessen im montierten Zustand dem Betrachter zugewandten Seite und parallel dazu eine Frontscheibe (1) aus transparentem Material angeordnet ist, bei der das Display (2) mit einem Träger (3) verbunden und entlang einer senkrecht zu den von den Oberflächen der Frontscheibe (1) und des Displays (2) definierten Ebenen verlaufenden Achse, zwischen einem ersten Punkt, der einem Minimalwert für den Abstand zwischen dem Display (2) und der Frontscheibe (1) entspricht und einem zweiten Punkt, der einem Maximalwert für den Abstand zwischen dem Display (2) und der Frontscheibe (1) entspricht, axial verschiebbar angeordnet und gelagert ist, wobei die Anzeigevorrichtung Mittel (4, 15) aufweist, mittels denen der Abstand zwischen dem Display (2) und der Frontscheibe (1) dynamisch in Abhängigkeit der Temperatur veränderbar ist, wobei bei Temperaturen, die einen unteren Schwellenwert unterschreiten, der Abstand den Minimalwert annimmt, und bei Temperaturen oberhalb des unteren Schwellenwertes der Abstand zwischen dem Display (2) und der Frontscheibe (1) in Abhängigkeit der Temperatur bis zu dem vorgegebenen Maximalwert erhöht wird, der einer oberen Temperaturschwelle entspricht.

## Beschreibung

Die vorliegende Erfindung bezieht sich auf eine Anzeigevorrichtung, insbesondere für im Freien aufgestellte Geräte, beispielsweise für Zugangskontrollvorrichtungen, Verkaufs- und Bezahlautomaten oder Digital-Signage-Geräten gemäß dem Oberbegriff des Patentanspruchs 1.

Anzeigevorrichtungen und Geräte umfassend Anzeigevorrichtungen, wie beispielsweise Zugangskontrollvorrichtungen, Verkaufs- und Bezahlautomaten sowie Digital-Signage-Geräte, werden oft im Freien aufgestellt, wodurch sie unterschiedlichen Wetterbedingungen ausgesetzt sind.

Hierbei kann es bei hohen Temperaturen oder bei direkter Sonneneinstrahlung in nachteiliger Weise zu Beeinträchtigungen der Qualität der Anzeigevorrichtungen kommen.

Des Weiteren kann bei hohen Außentemperaturen oder direkter Sonneneinstrahlung das elektronische Komponenten enthaltende Display der Anzeigevorrichtungen beschädigt werden.

Aus dem Stand der Technik ist bekannt, im Freien aufgestellte Anzeigevorrichtungen mittels eines Lüfters und geeigneter Luftkühlvorrichtungen mit kühler Luft zu versorgen. Hierbei kann jedoch das Display der Anzeigevorrichtungen nicht gleichmäßig oder vollständig gekühlt werden.

Des Weiteren ist aus dem Stand der Technik bekannt, das die Frontscheibe der Displays von Anzeigevorrichtungen mit einer weiteren Scheibe aus transparentem Material zu verbinden, derart, dass durch die weitere Scheibe aus transparentem Material, die Frontscheibe und die miteinander verklebten Ränder der Frontscheibe und der weiteren Scheibe aus transparentem Material ein quaderförmiger Hohlraum gebildet wird, der vollständig mit einer transparenten Flüssigkeit befüllbar ist, welche mittels eines geschlossenen Fluidkreislaufs umgewälzt wird, um eine vorgegebene Temperatur der sich im Hohlraum befindenden Flüssigkeit zu gewährleisten. Diese Lösung erweist sich jedoch als sehr kostenintensiv. Ferner ist ein hoher Wartungsaufwand erforderlich.

Der vorliegenden Erfindung liegt die Aufgabe zugrunde, eine Anzeigevorrichtung anzugeben, welche bei hohen Temperaturen und direkter Sonneneinstrahlung ohne die Gefahr einer temperaturbedingten Beschädigung betrieben werden kann.

Diese Aufgabe wird durch die Merkmale des Patentanspruchs 1 gelöst. Weitere erfindungsgemäße Ausgestaltungen und Vorteile gehen aus den Unteransprüchen hervor.

Demnach wird eine Anzeigevorrichtung vorgeschlagen, umfassend ein nach dem Stand der Technik ausgeführtes Display mit elektronischen Komponenten, vor dessen im montierten Zustand dem Betrachter zugewandten Seite und parallel dazu eine Frontscheibe aus transparentem Material angeordnet ist, wobei das Display mit einem Träger verbunden und entlang einer senkrecht zu den von den Oberflächen der Frontscheibe und des Displays definierten Ebenen verlaufenden Achse, zwischen einem ersten Punkt, der einem Minimalwert für den Abstand zwischen dem Display und der Frontscheibe entspricht und einem zweiten Punkt, der einem Maximalwert für den Abstand zwischen dem Display und der Frontscheibe entspricht axial verschiebbar angeordnet und gelagert ist, wobei die Anzeigevorrichtung Mittel aufweist, mittels denen der Abstand zwischen dem Display und der Frontscheibe aus transparentem Material dynamisch in Abhängigkeit der Temperatur veränderbar ist.

Die Lagerung des Trägers des Displays kann beispielsweise mittels Gleitstiften, die durch einen Träger der Frontscheibe oder einem ortsfesten Bauteil der Anzeigevorrichtung gebildet oder mit diesem verbunden sind und durch den Träger des Displays gebildete oder mit diesem verbundene Gleithülsen, in denen die Gleitstifte geführt sind, erfolgen. Die Gleitstifte und die korrespondierenden Gleithülsen sind hierbei an zumindest zwei gegenüberliegenden Seiten des Trägers der Frontscheibe oder des ortsfesten Bauteils und des Trägers des Displays vorgesehen, wobei deren Anzahl von den konstruktiven Gegebenheiten abhängt.

Gemäß weiterer Ausgestaltungen kann die Lagerung über Wälzlager oder Gummi-/Kunststoffgleitlager erfolgen. Ferner kann die Lagerung über eine Spindel erfolgen, die in eine mit dem Träger des Displays verbundene Gewindebuchse eingreift und am Träger der Frontscheibe oder an einem ortsfesten Bauteil der Anzeigevorrichtung über ein axial fixiertes, aber radial frei drehbares Lager befestigt ist; durch eine derartige Ausgestaltung werden Vibrationen weitgehend vermieden.

Bei niedrigen Temperaturen, d.h. bei Temperaturen, die einen unteren Schwellenwert unterschreiten, nimmt erfindungsgemäß der Abstand einen Minimalwert an, der vorzugsweise in der Größenordnung von einem halben Millimeter liegt, was in einer optimalen Ablesbarkeit und Bedienbarkeit, insbesondere für den Fall einer berührungsempfindlichen Anzeigevorrichtung resultiert.

Erfindungsgemäß wird bei Temperaturen oberhalb des unteren Schwellenwertes der Abstand zwischen dem Display und der Frontscheibe in Abhängigkeit der Temperatur bis zu dem vorgegebenen Maximalwert erhöht, der einer oberen Temperaturschwelle entspricht und vorzugsweise in der Größenordnung von einem Zentimeter liegt. Bei sinkenden Temperaturen wird im Intervall zwischen der oberen und der unteren Temperaturschwelle der Abstand zwischen dem Display und der Frontscheibe bis zum Minimalwert reduziert.

Gemäß der Erfindung können die Mittel zum Verändern des Abstandes zwischen dem Display und der Frontscheibe Bimetall-Elemente sein, die mit der Frontscheibe oder einem weiteren ortsfest angeordneten Bauteil, welches mit der Frontscheibe verbunden sein kann, und dem Träger des Displays verbunden oder wirkverbunden sind, welche derart angeordnet sind, dass deren Ausdehnung bei einer Temperaturerhöhung eine Vergrößerung des Abstandes zwischen dem Display und der Frontscheibe bewirkt, wobei bei Abkühlung das Schrumpfen der Bimetall-Elemente eine Verkürzung des Abstandes zwischen dem Display und der Frontscheibe bewirkt. Gemäß weiterer Ausgestaltungen kann der Schrumpfvorgang der Bimetall-Elemente bzw. die axiale Verschiebung des Displays bei Temperaturrückgang durch Rückstellfederelemente unterstützt werden.

Gemäß einer Ausgestaltung der Erfindung sind die Mittel zur Veränderung des Abstandes zwischen dem Display und der Frontscheibe Bimetallfedern, die jeweils um ein sich senkrecht zu den von den Oberflächen der Frontscheibe und des Displays definierten Ebenen erstreckendes vorzugsweise zylinderförmig ausgeführtes Profil angeordnet sind, dessen der Frontscheibe zugewandtes Ende entweder an einem Träger der Frontscheibe oder an einem weiteren Bauteil der Anzeigevorrichtung ortsfest angeordnet ist, wobei der Träger des Displays an zumindest einer Seite jeweils zumindest zwei Gleitstücke aufweist, die jeweils entlang eines Profils verschiebbar geführt sind und zwischen der jeweiligen Bimetallfeder und einer Rückstellfeder angeordnet sind, wobei die jeweilige Bimetallfeder zwischen dem jeweiligen Gleitstück und dem der Frontscheibe zugewandten Ende des Profils angeordnet ist und die jeweilige Rückstellfeder zwischen dem jeweiligen Gleitstück und dem der Frontscheibe abgewandten Ende des Profils angeordnet ist. Gemäß der Erfindung kann der Träger an zumindest zwei gegenüberliegenden Seiten jeweils zumindest zwei Gleitstücke aufweisen, die jeweils entlang eines Profils verschiebbar geführt sind.

Hierbei erfolgt die Vergrößerung des Abstandes zwischen dem Display und der Frontscheibe durch eine axiale Verschiebung des Trägers aufgrund der Ausdehnung der Bimetallfedern in Abhängigkeit der Temperatur gegen die Kraft der jeweiligen Rückstellfeder. Die Rückstellfedern sind derart ausgelegt, dass diese eine Vergrößerung des Abstandes zwischen der Frontscheibe und dem Display bis zu dem vorgegebenen Maximalwert ermöglichen, wobei die axiale Position der Gleitstücke in Abhängigkeit der Temperatur durch das Kräftegleichgewicht zwischen der jeweiligen Bimetallfeder und der Rückstellfeder definiert ist. Ferner sind die Bimetallfedern derart ausgelegt, dass der vorgegebene Minimalwert des Abstandes zwischen der Frontscheibe und dem Display nicht unterschritten wird.

Im Rahmen einer weiteren Ausgestaltung sind die Bimetallfedern jeweils um einen sich senkrecht zu den von den Oberflächen der Frontscheibe und des Displays definierten Ebenen erstreckenden zylinderförmig ausgeführten Gleitstift angeordnet, dessen der Frontscheibe zugewandtes Ende entweder mit einem Träger der Frontscheibe oder mit einem weiteren Bauteil der Anzeigevorrichtung verbunden ist, wobei der Träger des Displays an zumindest zwei gegenüberliegenden Seiten jeweils zumindest eine Gleithülse aufweist, in die jeweils ein Gleitstift geführt ist, wobei sich die Bimetallfedern am Träger der Frontscheibe bzw. am weiteren Bauteil und am Träger des Displays abstützen und bei Temperaturerhöhung den Träger des Displays gegen die Kraft jeweils einer Rückstellfeder in Richtung von der Frontscheibe weg verschieben.

Gemäß einer weiteren Ausgestaltung umfassen die Mittel zur Veränderung des Abstandes zwischen dem Display und der Frontscheibe zumindest einen mit der Frontscheibe oder mit einem mit der Frontscheibe verbundenen Bauteil an seinen Enden verbundenen Bimetallstreifen, der am Träger des Displays anliegt oder mit diesem verbunden ist, sich bei Temperaturerhöhung in Richtung auf das Display wölbt und dieses gegen die Kraft jeweils zumindest einer Rückstellfeder axial in Richtung von der Frontscheibe weg verschiebt. Bei Temperaturrückgang wird der Schrumpfvorgang des zumindest einen Bimetallstreifens durch die zumindest eine Rückstellfeder unterstützt, wobei der Abstand zwischen dem Display und der Frontscheibe entsprechend der Temperatur verringert wird. Die zumindest eine Rückstellfeder ist derart ausgelegt, dass diese eine Vergrößerung des Abstandes zwischen der Frontscheibe und dem Display bis zu dem vorgegebenen Maximalwert ermöglicht, wobei die axiale Position des Displays in Abhängigkeit der Temperatur durch das Kräftegleichgewicht zwischen den Bimetallstreifen und der zumindest einen Rückstellfeder definiert ist. Die Bimetallstreifen sind derart ausgelegt, dass der vorgegebene Minimalwert des Abstandes zwischen der Frontscheibe und dem Display nicht unterschritten wird. Die Bimetallstreifen sind vorzugsweise an deren dem Display zugewandten Seite mit dem Träger des Displays form- oder kraftschlüssig verbunden.

Gemäß einer weiteren Ausgestaltung umfassen die Mittel zur Veränderung des Abstandes zwischen dem Display und der Frontscheibe zumindest einen gewölbten Bimetallstreifen, dessen ein Ende mit der Frontscheibe oder einem mit der Frontscheibe verbundenen Bauteil verbunden ist und dessen anderes Ende mit dem Träger des Displays verbunden ist, der sich bei Temperaturerhöhung ausdehnt und das Display axial in Richtung von der Frontscheibe weg verschiebt. Bei Temperaturrückgang wird der Abstand zwischen dem Display und der Frontscheibe entsprechend der Temperatur bedingt durch den Schrumpfvorgang der Bimetallstreifen verringert. Optional kann der Schrumpfvorgang der Bimetallstreifen durch zumindest ein Rückstellfederelement unterstützt werden.

Im Rahmen einer weiteren erfindungsgemäßen Ausgestaltung sind die Mittel zur Veränderung des Abstandes zwischen der Frontscheibe und dem Display in Abhängigkeit der Temperatur als zumindest ein elektrischer, pneumatischer, hydraulischer oder elektromagnetischer Aktuator ausgeführt, welcher in Abhängigkeit der von zumindest einem Sensor erfassten Temperatur von einer Steuerung gesteuert wird, um einen vorgegebenen Abstand zwischen dem Display und der Frontscheibe in Abhängigkeit der Temperatur einzustellen. Hierbei kann der Abstand zwischen der Frontscheibe und dem Display als Funktion der Temperatur in einer in einer Steuerung hinterlegten Kennlinie abgelegt sein. Im Rahmen einer Weiterbildung der Erfindung kann zudem ein Näherungssensor vorgesehen sein, wobei, wenn mittels des Sensors die Anwesenheit einer Person vor der Anzeigevorrichtung detektiert wird und der Abstand zwischen dem Display und der Frontscheibe nicht dem Minimalwert entspricht, der zumindest eine Aktuator betätigt wird, um den Abstand zwischen der Frontscheibe und dem Display auf den Minimalwert zu reduzieren, so dass während der Anwesenheit der Person eine optimale Ablesbarkeit und Bedienbarkeit trotz hoher Temperaturen gewährleistet wird.

Die Erfindung wird im Folgenden anhand der beigefügten Figuren beispielhaft näher erläutert. Gleiche Bezugszeichen bezeichnen gleiche Bauteile. Der allgemeine Aufbau von Anzeigevorrichtungen ist dem Fachmann bestens bekannt so dass im Folgenden die Merkmale gezeigt und detailliert beschrieben werden, die für die vorliegende Erfindung von Bedeutung sind. Beispielsweise werden das Gehäuse und die zum Betrieb des Displays erforderlichen elektronischen Komponenten nicht dargestellt. Es zeigen:
Figur 1: Eine schematische Schnittansicht eines Teiles einer erfindungsgemäß ausgeführten Anzeigevorrichtung, bei der der Abstand zwischen der Frontscheibe und dem Display dem Minimalwert entspricht;
Figur 2: Eine schematische Schnittansicht eines Teiles der Anzeigevorrichtung nach Figur 1, bei der der Abstand zwischen der Frontscheibe und dem Display dem Maximalwert entspricht;
Figur 3: Eine schematische Frontansicht der Frontscheibe einer Ausgestaltung einer erfindungsgemäß ausgeführten Anzeigevorrichtung;
Figur 4: Eine schematische perspektivische Ansicht der Anzeigevorrichtung nach Figur 3;
Figur 5: Einen Schnitt entlang der Linie A-A aus Figur 3;
Figur 6: Einen Schnitt entlang der Linie B-B aus Figur 3;
Figur 7: Eine schematische perspektivische Ansicht einer weiteren Ausgestaltung einer erfindungsgemäßen Anzeigevorrichtung;
Figur 8: Eine schematische Rückansicht der Anzeigevorrichtung der nach Figur 7 (rechter Teil) und einen Schnitt entlang der Linie A-A (linker Teil);
Figur 9: Eine schematische perspektivische Ansicht einer weiteren Ausgestaltung einer erfindungsgemäßen Anzeigevorrichtung;
Figur 10: Eine schematische Rückansicht der Anzeigevorrichtung der nach Figur 9;
Figur 11: Einen Schnitt entlang der Linie A-A aus Figur 10;
Figur 12: Eine schematische Frontansicht der Frontscheibe einer Ausgestaltung einer erfindungsgemäß ausgeführten Anzeigevorrichtung;
Figur 13: Einen Schnitt entlang der Linie B-B aus Figur 12;
Figur 14: Einen Schnitt entlang der Linie C-C aus Figur 12;
Figur 15: Einen Schnitt entlang der Linie A-A aus Figur 12;
Figur 16: Eine Schnittansicht entlang der Linie D-D aus Figur 15;
Figur 17: Eine Schnittansicht einer weiteren Ausgestaltung der Erfindung zur Veranschaulichung einer möglichen Anordnung eines Aktuators; und
Figur 18: Eine schematische perspektivische Ansicht einer weiteren Ausgestaltung einer erfindungsgemäßen Anzeigevorrichtung, bei der zumindest ein Aktuator vorgesehen ist.

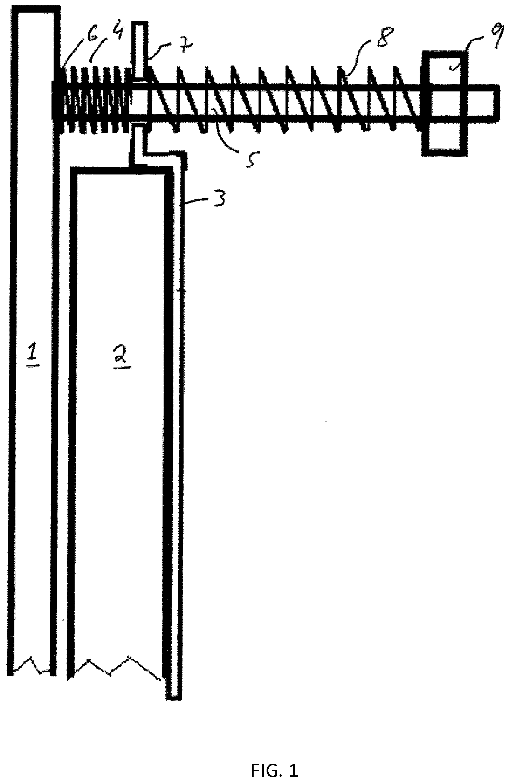

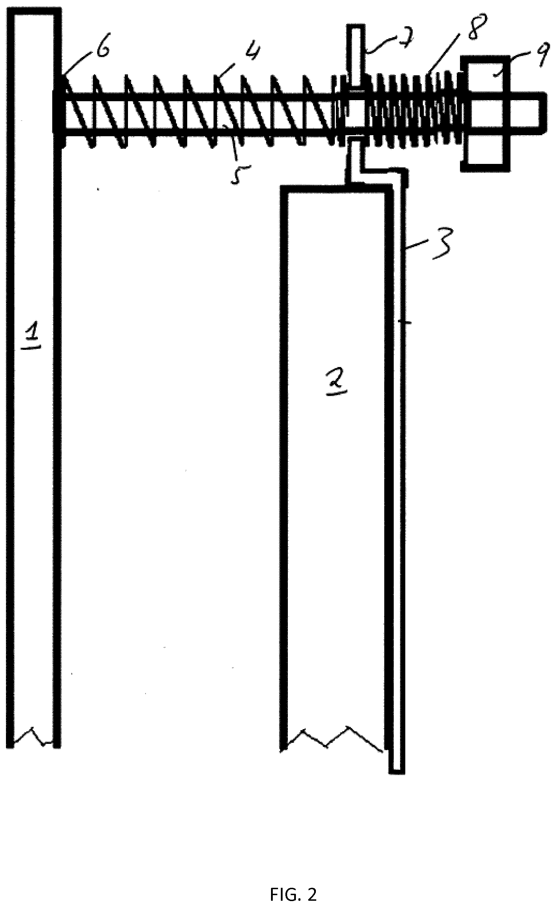

In Figuren 1 und 2 sind mit 1 die Frontscheibe und mit 2 das Display der Anzeigevorrichtung bezeichnet, wobei der Träger des Displays 2 mit 3 bezeichnet ist. Hierbei wird die obere Seite der Anzeigevorrichtung dargestellt; die untere Seite ist analog zu der oberen Seite aufgebaut.

Bei dem gezeigten Beispiel sind die Mittel zur Veränderung des Abstandes zwischen dem Display 2 und der Frontscheibe 1 Bimetallfedern 4, die jeweils um ein sich senkrecht zu den von den Oberflächen der Frontscheibe 1 und des Displays 2 definierten Ebenen erstreckendes zylinderförmig ausgeführtes Profil 5 angeordnet sind, dessen der Frontscheibe zugewandtes Ende an einem Träger 6 der Frontscheibe 1 angeordnet ist.

Bezugnehmend auf Figuren 1 und 2, weist der Träger 3 des Displays 2 an der oberen und unteren Seite jeweils zwei Gleitstücke 7 auf (in Figuren 1 und 2 ist nur ein Gleitstück dargestellt), die jeweils entlang eines Profils 5 verschiebbar geführt sind und zwischen der jeweiligen Bimetallfeder 4 und einer Rückstellfeder 8 angeordnet sind, wobei die jeweilige Bimetallfeder 4 zwischen dem jeweiligen Gleitstück 7 und dem der Frontscheibe 1 zugewandten Ende des Profils 5 angeordnet ist und die jeweilige Rückstellfeder 8 zwischen dem jeweiligen Gleitstück 7 und dem der Frontscheibe abgewandten Ende des Profils 5 angeordnet ist und sich gegen einen Anschlag 9 abstützt.

Die Vergrößerung des Abstandes zwischen dem Display 2 und der Frontscheibe 1 erfolgt durch eine axiale Verschiebung des mit dem Display 2 verbundenen Trägers 3 aufgrund der Ausdehnung der Bimetallfedern 4 in Abhängigkeit der Temperatur gegen die Kraft der jeweiligen Rückstellfeder 8. Die Rückstellfedern 8 sind derart ausgelegt, dass diese eine Vergrößerung des Abstandes zwischen der Frontscheibe 1 und dem Display 2 bis zu dem vorgegebenen Maximalwert ermöglichen, wobei die axiale Position der Gleitstücke 7 in Abhängigkeit der Temperatur durch das Kräftegleichgewicht zwischen der jeweiligen Bimetallfeder 4 und der Rückstellfeder 8 definiert ist, wobei die Bimetallfedern 4 derart ausgelegt sind, dass der vorgegebene Minimalwert des Abstandes zwischen der Frontscheibe 1 und dem Display 2 nicht unterschritten wird. Zwischen den Profilen 5 und den Gleitstücken 7 ist der Reibwert möglichst gering.

In Figur 1 ist die Anzeigevorrichtung in einem Zustand gezeigt, bei dem der Abstand zwischen der Frontscheibe 1 und dem Display 2 dem Minimalwert entspricht, wobei Figur 2 die Anzeigevorrichtung in einem Zustand darstellt, bei dem der Abstand zwischen der Frontscheibe 1 und dem Display 2 dem Maximalwert entspricht.

Bei der Ausgestaltung gemäß Figuren 1 und 2 sind die Profile 5 und die Gleitstücke 7 an der oberen und unteren Seite des Displays vorgesehen; im Rahmen weiterer Ausgestaltungen können die Profile 5 und die Gleitstücke 7 an der rechten und linken Seite des Displays vorgesehen sein.

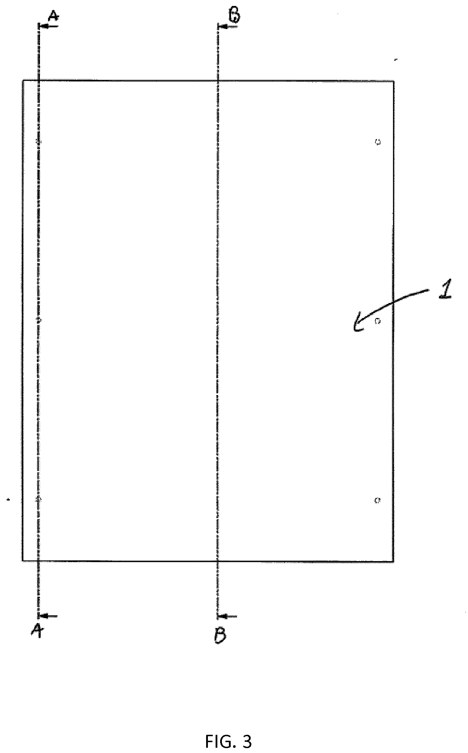

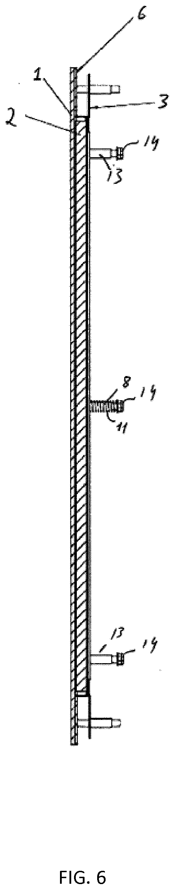

Gemäß einer weiteren Ausgestaltung der Erfindung und bezugnehmend auf Figuren 3, 4, 5 und 6 sind die als Mittel zur Veränderung des Abstandes zwischen der Frontscheibe und dem Display in Abhängigkeit der Temperatur dienenden Bimetallfedern 4 jeweils um einen sich senkrecht zu den von den Oberflächen der Frontscheibe 1 und des Displays 2 definierten Ebenen erstreckenden zylinderförmig ausgeführten Gleitstift 10 angeordnet, dessen der Frontscheibe 1 zugewandtes Ende mit dem Träger 6 der Frontscheibe 1 verbunden ist. Hierbei weist der Träger 3 des Displays 2 an zumindest zwei gegenüberliegenden Seiten jeweils zumindest eine Gleithülse 11 auf, in die jeweils ein Stift 10 geführt ist. Gemäß weiterer Ausgestaltungen können weitere Gleithülsen vorgesehen sein, in die jeweils ein Stift geführt ist, um den eine Bimetallfeder angeordnet ist. Bei dem gezeigten Beispiel ist jeweils an zwei gegenüberliegenden Seiten der Träger 3, 6 des Displays 2 und der Frontscheibe 1 jeweils ein Gleitstift 10 und eine Gleithülse 11 vorgesehen.

Bei dem gezeigten Beispiel erfolgt die Lagerung des Trägers des Displays mittels Gleitstiften 12, die durch den Träger 6 der Frontscheibe 1 gebildet oder mit diesem verbunden sind und durch den Träger 3 des Displays 2 gebildete oder mit diesem verbundene Gleithülsen 13, in denen die Gleitstifte 12 geführt sind. Diese Lagerung ist unabhängig von der Art der Mittel zur Veränderung des Abstandes zwischen der Frontscheibe und dem Display in Abhängigkeit der Temperatur und kann beispielsweise auch bei dem Ausführungsbeispiel nach Figuren 1 und 2 oder bei Ausgestaltungen, bei denen die Mittel zur Veränderung des Abstandes zwischen der Frontscheibe und dem Display in Abhängigkeit der Temperatur als zumindest ein elektrischer, pneumatischer, hydraulischer oder elektromagnetischer Aktuator ausgeführt sind, vorgesehen sein.

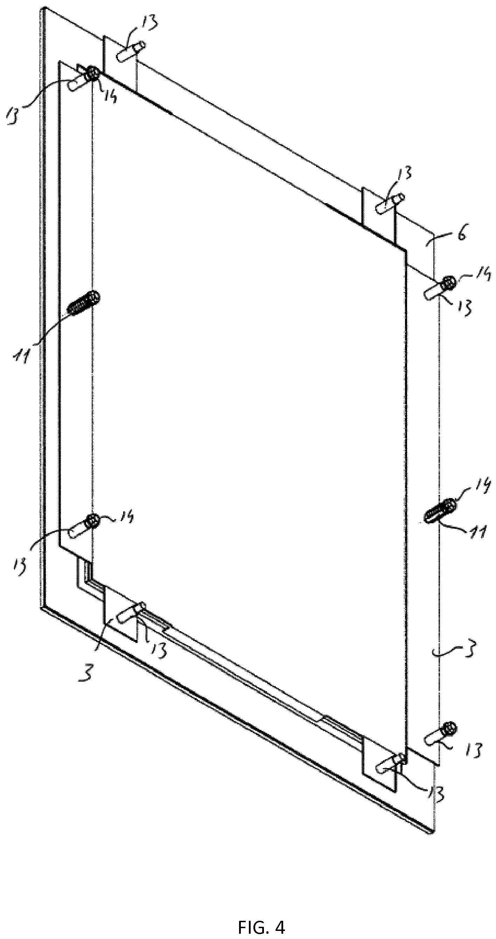

In Figur 3 ist die Frontseite der Frontscheibe 1 der Anzeigevorrichtung dargestellt. In der perspektivischen Ansicht gemäß Figur 4 bezeichnet 6 den Träger der Frontscheibe, 3 den Träger des Displays, 13 die Hülsen, in denen Gleitstifte zur Lagerung geführt sind und 11 die Hülsen, in die ein jeweils Stift, um den eine Bimetallfeder 4 angeordnet ist, geführt ist.

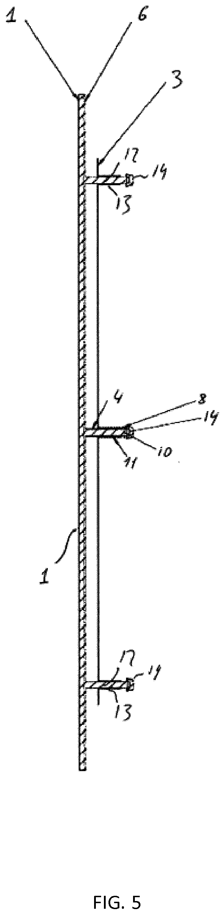

Aus Figur 5, welche einen Schnitt entlang der Linie A-A aus Figur 3 darstellt, ist ersichtlich, dass sich die Bimetallfedern 4 am Träger 6 der Frontscheibe 1 und am Träger 3 des Displays 2 abstützen, so dass bei Temperaturerhöhung der Träger 3 des Displays 2 gegen die Kraft jeweils einer Rückstellfeder 8 in Richtung von der Frontscheibe 1 weg verschoben wird. In Figuren 4, 5 und 6 sind Endkappen für die Hülsen 11, 13 mit dem Bezugszeichen 14 versehen.

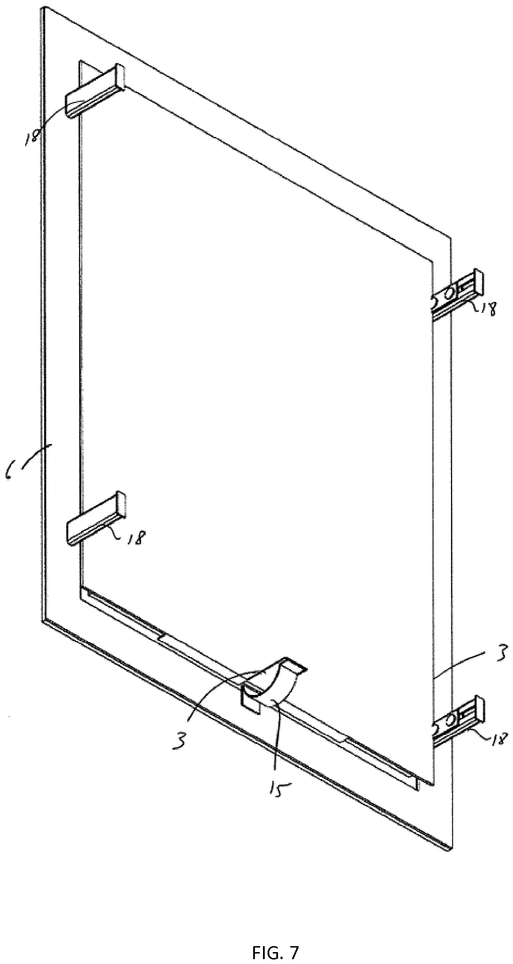

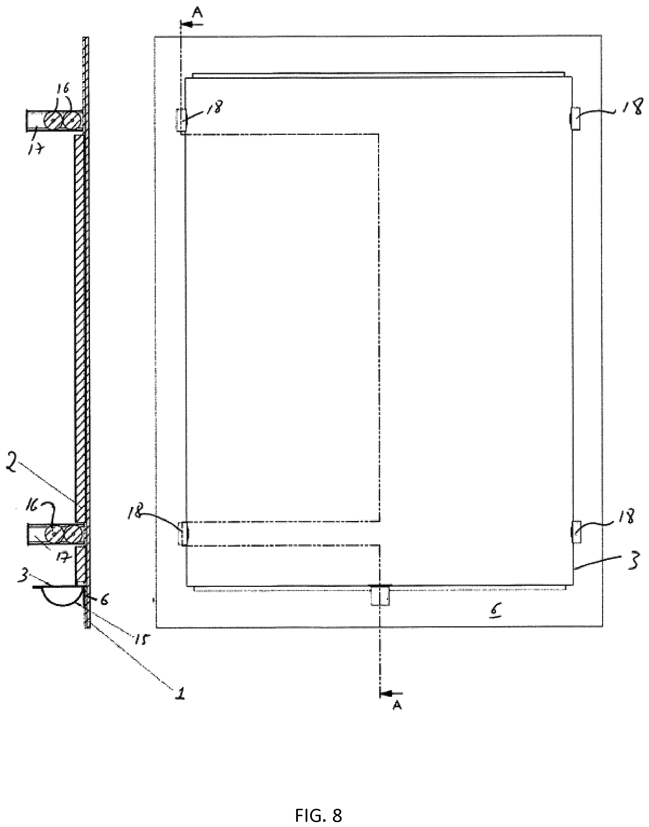

Gegenstand der Figuren 7 und 8 ist eine weitere Ausgestaltung der Erfindung, bei der als Mittel zur Veränderung des Abstandes zwischen dem Display 2 und der Frontscheibe 1 ein gewölbter Bimetallstreifen 15 vorgesehen ist, dessen ein Ende mit dem Träger 6 der Frontscheibe 1 verbunden, beispielsweise verklebt oder verschweißt ist und dessen anderes Ende mit dem Träger 3 des Displays 2 verbunden ist, der sich bei Temperaturerhöhung ausdehnt und das Display 2 axial in Richtung von der Frontscheibe 1 weg verschiebt. Bei Temperaturrückgang wird der Abstand zwischen dem Display und der Frontscheibe entsprechend der Temperatur bedingt durch den Schrumpfvorgang des Bimetallstreifens 15 verringert, wobei optional der Schrumpfvorgang des Bimetallstreifens durch zumindest ein Rückstellfederelement unterstützt werden kann. Im Rahmen weiterer Ausgestaltungen können weitere Bimetallstreifen vorgesehen sein.

Bei dem in Figuren 7 und 8 gezeigten Beispiel erfolgt die Lagerung des Trägers 3 des Displays 2 mittels am Träger 3 des Displays drehbar gelagerter Kunststoff- oder Gummirollen 16, die in einer mit dem Träger 6 der Frontscheibe 1 verbundenen Laufschiene 17 geführt sind und jeweils eine Lagereinheit 18 bilden. Hierbei sind an zumindest zwei gegenüberliegenden Seiten des Displays 2 und der Frontscheibe 1 zumindest zwei Lagereinheiten vorgesehen. Diese Lagerung ist unabhängig von der Art der Mittel zur Veränderung des Abstandes zwischen der Frontscheibe und dem Display in Abhängigkeit der Temperatur und kann beispielsweise auch bei den Ausführungsbeispielen nach Figuren 1, 2, 3, 4, 5 und 6 oder bei Ausgestaltungen, bei denen die Mittel zur Veränderung des Abstandes zwischen der Frontscheibe und dem Display in Abhängigkeit der Temperatur als zumindest ein elektrischer, pneumatischer, hydraulischer oder elektromagnetischer Aktuator ausgeführt sind, vorgesehen sein.

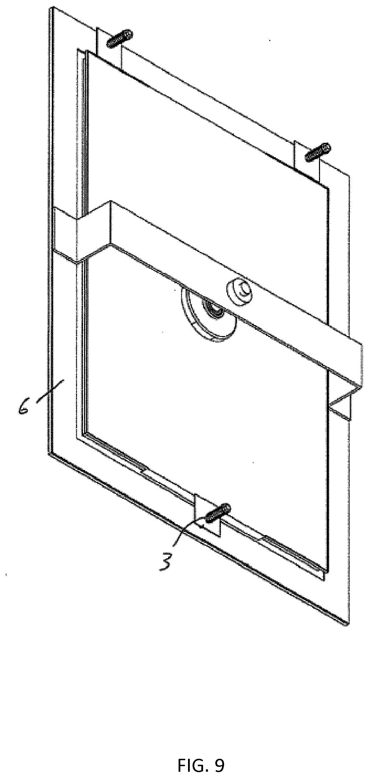

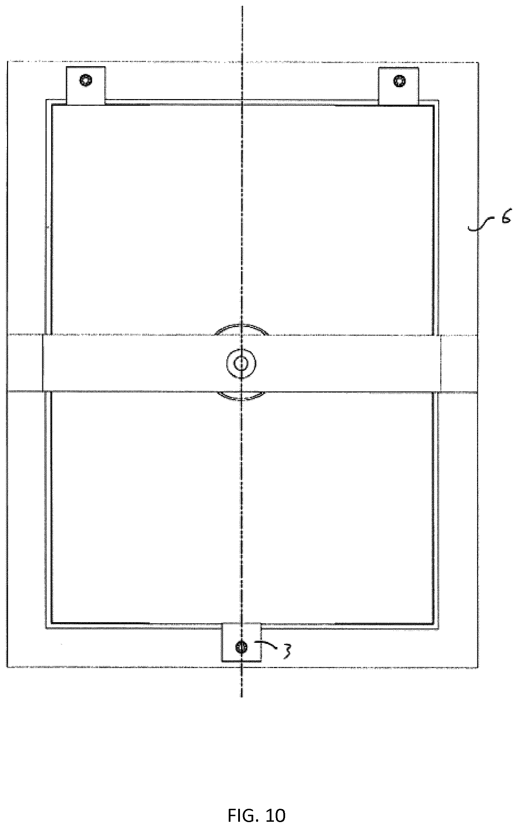

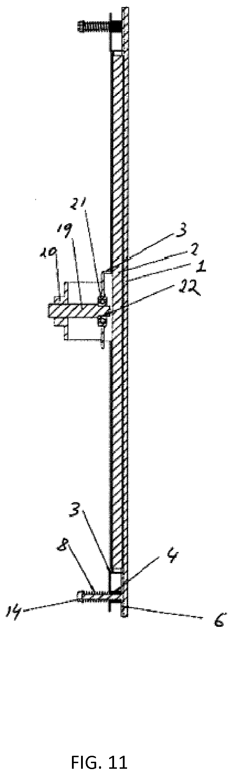

Gegenstand der Figuren 9, 10 und 11 ist eine weitere Ausgestaltung der Erfindung, bei der als Mittel zur Veränderung des Abstandes zwischen der Frontscheibe und dem Display in Abhängigkeit der Temperatur und analog zum Ausführungsbeispiel nach Figuren 3, 4 und 5 Bimetallfedern 4 vorgesehen sind, die jeweils um einen sich senkrecht zu den von den Oberflächen der Frontscheibe 1 und des Displays 2 definierten Ebenen erstreckenden zylinderförmig ausgeführten Gleitstift 10 angeordnet sind, dessen der Frontscheibe 1 zugewandtes Ende mit dem Träger 6 der Frontscheibe 1 verbunden ist, wobei der Träger 3 des Displays 2 an zumindest zwei gegenüberliegenden Seiten jeweils zumindest eine Gleithülse 11 aufweist, in die jeweils ein Stift 10 geführt ist. Bei dem gezeigten Beispiel sind an der oberen Seite der Träger 3, 6 des Displays 2 und der Frontscheibe 1 zwei Gleitstifte 10 und zwei Gleithülsen 11 vorgesehen, wobei an der unteren Seite ein Gleitstift 10 und eine Gleithülse 11 vorgesehen ist. Die Bimetallfedern 4 stützen sich am Träger 6 der Frontscheibe 1 und am Träger 3 des Displays 2 ab, so dass bei Temperaturerhöhung der Träger 3 des Displays 2 gegen die Kraft jeweils einer Rückstellfeder 8 in Richtung von der Frontscheibe 1 weg verschoben wird.

Die Lagerung des Trägers 3 des Displays 2 der Anzeigevorrichtung erfolgt bei dem gezeigten Beispiel über eine Spindel 19, die in eine mit dem Träger 3 des Displays 2 verbundene Gewindebuchse 20 eingreift und am Träger 6 der Frontscheibe 1 über ein axial fixiertes, aber radial frei drehbares Kugellager 21 mittels beispielsweise einer Pressverbindung 22 befestigt ist. Diese Lagerung ist unabhängig von der Art der Mittel zur Veränderung des Abstandes zwischen der Frontscheibe und dem Display in Abhängigkeit der Temperatur und kann beispielsweise auch bei den Ausführungsbeispielen nach Figuren 1, 2, 3, 4, 5, 6, 7 und 8 oder bei Ausgestaltungen, bei denen die Mittel zur Veränderung des Abstandes zwischen der Frontscheibe und dem Display in Abhängigkeit der Temperatur als zumindest ein elektrischer, pneumatischer, hydraulischer oder elektromagnetischer Aktuator ausgeführt sind, vorgesehen sein.

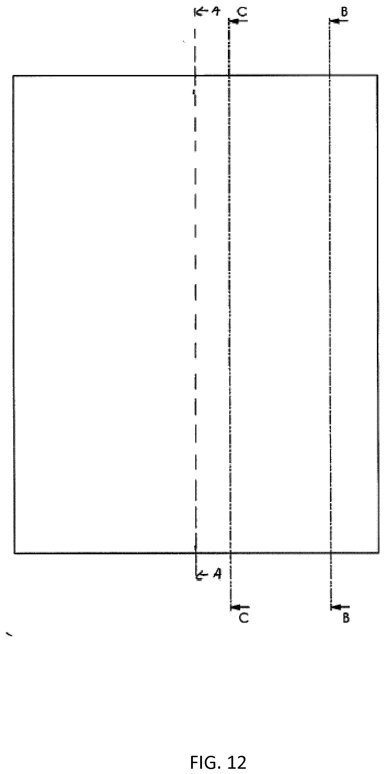

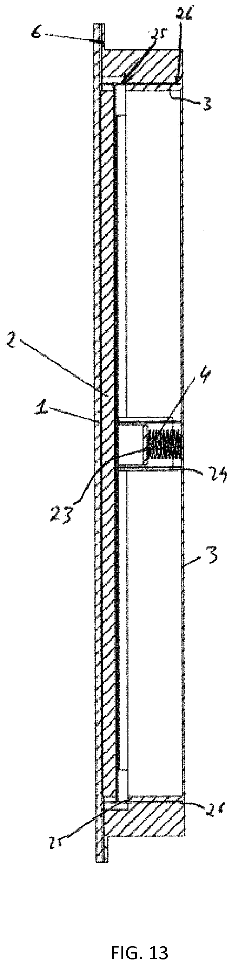

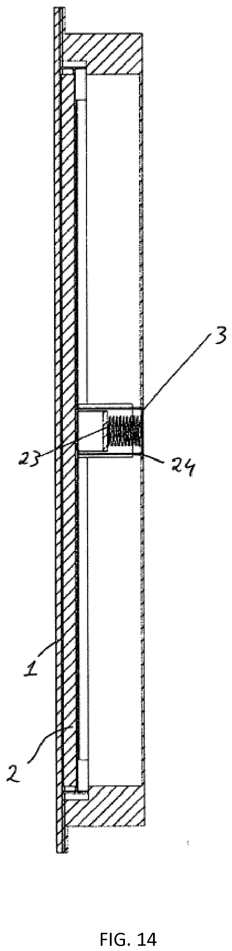

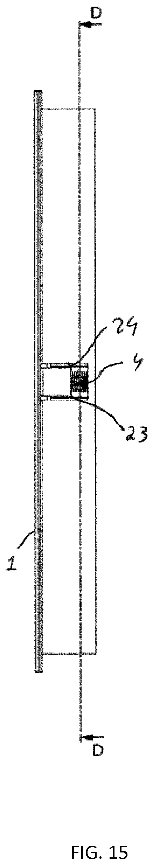

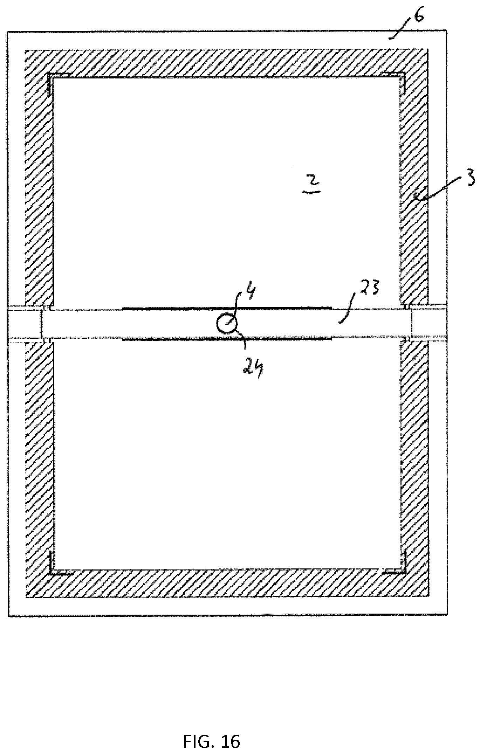

Gegenstand der Figuren 12, 13, 14, 15 und 16 ist eine Ausgestaltung der Erfindung, bei der als Mittel zur Veränderung des Abstandes zwischen dem Display 2 und der Frontscheibe 1 eine Bimetallfeder 4 zentral an der Rückseite des Displays 2 vorgesehen ist, welche an dem dem Display abgewandten Ende mit dem Träger 3 des Displays 2 oder mit einem mit dem Träger verbundenen Bauteil verbunden ist, wobei das andere, dem Display 2 zugewandte Ende mit einem ortsfest angeordneten Bauteil in der Anzeigevorrichtung verbunden ist, welches zwischen dem Display 2 und dem Träger 3 des Displays oder dem mit dem Träger verbundenen Bauteil angeordnet ist, derart, dass bei Temperaturerhöhung der Abstand zwischen dem Display 2 und der Frontscheibe 1 erhöht wird. Wie aus Figuren 13 und 14 ersichtlich, ist der Träger 3 des Displays 2 derart ausgeführt, dass zwischen der der Frontscheibe 1 angewandten Seite des Displays 2 und dem Träger 3 Bauraum vorgesehen ist, in dem ein ortsfest angeordnetes Bauteil 23 angeordnet ist, mit dem das dem Display 2 zugewandte Ende der Bimetallfeder 4 verbunden ist. Die Bimetallfeder ist bei dem gezeigten Beispiel in einer Hülse 24 geführt. Anstelle der gezeigten Bimetallfeder 4 kann auch ein gewölbter Bimetallstreifen verwendet werden. Optional kann zur Unterstützung des Schrumpfvorgangs der Bimetallfeder 4 oder des Bimetallstreifens zumindest ein Rückstellfederelement vorgesehen sein.

Bei der in Figuren 12-16 gezeigten Ausgestaltung der Anzeigevorrichtung erfolgt die Lagerung des Trägers 3 des Displays 2 mittels im Träger 3 des Displays 2 vorgesehener Federn 25, die in im Träger 6 der Frontscheibe 1 vorgesehenen Nuten 26 eingreifen. Diese Lagerung ist unabhängig von der Art der Mittel zur Veränderung des Abstandes zwischen der Frontscheibe 1 und dem Display 2 in Abhängigkeit der Temperatur und kann beispielsweise auch bei sämtlichen gezeigten Ausführungsbeispielen oder bei Ausgestaltungen, bei denen die Mittel zur Veränderung des Abstandes zwischen der Frontscheibe und dem Display in Abhängigkeit der Temperatur als zumindest ein elektrischer, pneumatischer, hydraulischer oder elektromagnetischer Aktuator ausgeführt sind, vorgesehen sein.

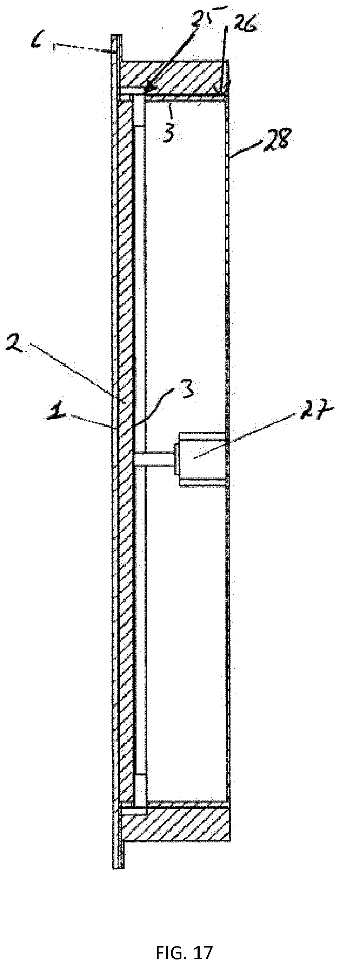

Das Ausführungsbeispiel nach Figur 17 entspricht hinsichtlich der Lagerung dem Ausführungsbeispiel nach Figuren 12, 13, 14, 15 und 16, wobei anstelle der zentral an der Rückseite des Displays 2 vorgesehenen Bimetallfeder ein an einem ortsfesten Bauteil 28 angeordneter linearer Aktuator 27 vorgesehen ist, welcher mit der Rückseite des Displays 2 oder mit dem Träger 3 des Displays 2 verbunden ist, so dass das Display 3 axial verschoben werden kann.

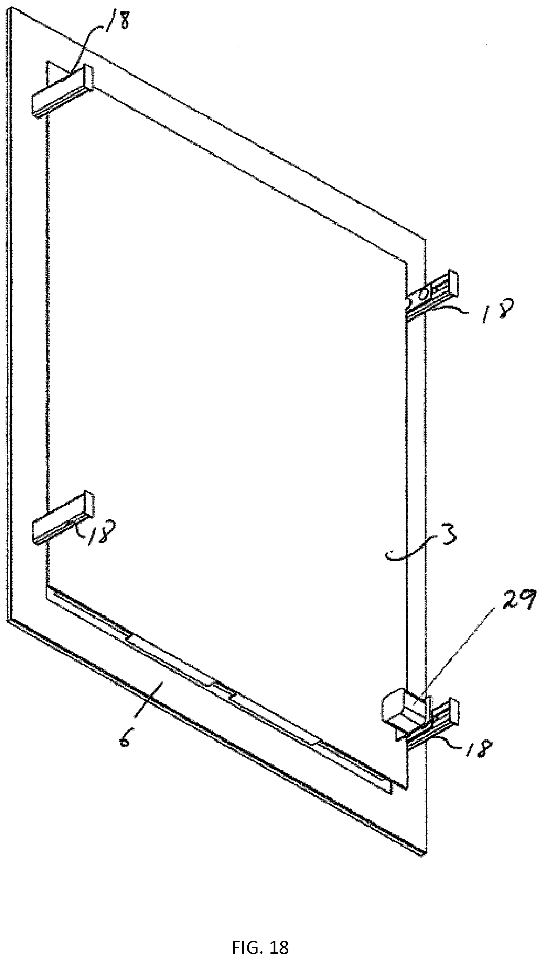

Ferner unterscheidet sich das in Figur 18 dargestellte Ausführungsbeispiel vom Ausführungsbeispiel nach Figuren 7 und 8 dadurch, dass der gewölbte Bimetallstreifen entfällt, wobei ein Aktuator 29 vorgesehen ist, welcher mit dem Träger 3 des Displays 2 verbunden ist und die in einer Laufschiene 17 geführten Rollen 16 einer Lagereinheit 18 antreibt. Hierbei können die Rollen 16 auch als Zahnräder ausgeführt sein, die in entsprechenden Zahnstrukturen der Laufschiene 17 eingreifen. Bei dem gezeigten Beispiel ist ein Aktuator 29 vorgesehen, der einer Lagereinheit 18 zugeordnet ist. Im Rahmen weiterer Ausgestaltungen kann zumindest einer weiteren Lagereinheit 18 jeweils ein weiterer Aktuator zugeordnet sein.

Gemäß der Erfindung kann bei jeder gezeigten Ausgestaltung das zumindest eine Bimetallelement durch einen Aktuator ersetzt werden, der einerseits mit dem Display 2 oder dem Träger 3 des Displays 2 und anderseits mit einem ortsfest angeordneten Bauteil verbunden ist.

Die unterschiedlichen Lagerungskonzepte können mit den unterschiedlichen Ausgestaltungen der Mittel zur Veränderung des Abstandes zwischen der Frontscheibe 1 und dem Display 2 in Abhängigkeit der Temperatur beliebig kombiniert werden.

Wenn Rückstellfederelemente vorgesehen sind, sind diese derart ausgelegt, dass sie eine Vergrößerung des Abstandes zwischen der Frontscheibe und dem Display bis zu dem vorgegebenen Maximalwert ermöglichen, wobei die axiale Position des Displays in Abhängigkeit der Temperatur durch das Kräftegleichgewicht zwischen den Bimetallelementen und dem zumindest einen Rückstellfederelement definiert ist. Die Bimetallelemente sind derart ausgelegt, dass der vorgegebene Minimalwert des Abstandes zwischen der Frontscheibe und dem Display nicht unterschritten wird.

## Patentansprüche

1. Anzeigevorrichtung, umfassend ein Display (2) mit elektronischen Komponenten, vor dessen im montierten Zustand dem Betrachter zugewandten Seite und parallel dazu eine Frontscheibe (1) aus transparentem Material angeordnet ist, **dadurch gekennzeichnet, dass** das Display (2) mit einem Träger (3) verbunden und entlang einer senkrecht zu den von den Oberflächen der Frontscheibe (1) und des Displays (2) definierten Ebenen verlaufenden Achse, zwischen einem ersten Punkt, der einem Minimalwert für den Abstand zwischen dem Display (2) und der Frontscheibe (1) entspricht und einem zweiten Punkt, der einem Maximalwert für den Abstand zwischen dem Display (2) und der Frontscheibe (1) entspricht, axial verschiebbar angeordnet und gelagert ist, wobei die Anzeigevorrichtung Mittel (4, 15) aufweist, mittels denen der Abstand zwischen dem Display (2) und der Frontscheibe (1) dynamisch in Abhängigkeit der Temperatur veränderbar ist, wobei bei Temperaturen, die einen unteren Schwellenwert unterschreiten, der Abstand den Minimalwert annimmt, und bei Temperaturen oberhalb des unteren Schwellenwertes der Abstand zwischen dem Display (2) und der Frontscheibe (1) in Abhängigkeit der Temperatur bis zu dem vorgegebenen Maximalwert erhöht wird, der einer oberen Temperaturschwelle entspricht.

2. Anzeigevorrichtung nach Anspruch 1, **dadurch gekennzeichnet, dass** die Mittel zum Verändern des Abstandes zwischen dem Display (2) und der Frontscheibe (1) Bimetall-Elemente (4, 15) sind, die mit der Frontscheibe (1) oder einem weiteren ortsfest angeordneten Bauteil, welches mit der Frontscheibe (1) verbunden sein kann, und dem Träger (3) des Displays (2) verbunden oder wirkverbunden sind, welche derart angeordnet sind, dass deren Ausdehnung bei einer Temperaturerhöhung eine Vergrößerung des Abstandes zwischen dem Display (2) und der Frontscheibe (1) bewirkt, wobei bei Abkühlung das Schrumpfen der Bimetall-Elemente (4, 15) eine Verkürzung des Abstandes zwischen dem Display (2) und der Frontscheibe (1) bewirkt, wobei der Schrumpfvorgang der Bimetall-Elemente bzw. die axiale Verschiebung des Displays (2) bei Temperaturrückgang optional durch Rückstellfederelemente (8) unterstützt wird.

3. Anzeigevorrichtung nach Anspruch 2, **dadurch gekennzeichnet, dass** die Mittel zur Veränderung des Abstandes zwischen dem Display (2) und der Frontscheibe (1) Bimetallfedern (4) sind, die jeweils um ein sich senkrecht zu den von den Oberflächen der Frontscheibe (1) und des Displays (2) definierten Ebenen erstreckendes Profil (5) angeordnet sind, dessen der Frontscheibe (1) zugewandtes Ende entweder an einem Träger (6) der Frontscheibe (1) oder an einem weiteren Bauteil der Anzeigevorrichtung ortsfest angeordnet ist, wobei der Träger (3) des Displays (2) an zumindest einer Seite jeweils zumindest zwei Gleitstücke (7) aufweist, die jeweils entlang eines Profils (5) verschiebbar geführt sind und zwischen der jeweiligen Bimetallfeder (4) und einer Rückstellfeder (8) angeordnet sind, wobei die jeweilige Bimetallfeder (4) zwischen dem jeweiligen Gleitstück (7) und dem der Frontscheibe (1) zugewandten Ende des Profils (5) angeordnet ist und die jeweilige Rückstellfeder (8) zwischen dem jeweiligen Gleitstück (7) und dem der Frontscheibe (1) abgewandten Ende des Profils (5) angeordnet ist.

4. Anzeigevorrichtung nach Anspruch 2, **dadurch gekennzeichnet, dass** die Mittel zur Veränderung des Abstandes zwischen dem Display (2) und der Frontscheibe (1) Bimetallfedern (4) sind, die jeweils um einen sich senkrecht zu den von den Oberflächen der Frontscheibe (1) und des Displays (2) definierten Ebenen erstreckenden zylinderförmig ausgeführten Gleitstift (10) angeordnet sind, dessen der Frontscheibe (1) zugewandtes Ende entweder mit einem Träger (6) der Frontscheibe (1) oder mit einem weiteren Bauteil der Anzeigevorrichtung verbunden ist, wobei der Träger (3) des Displays (2) an zumindest zwei gegenüberliegenden Seiten jeweils zumindest eine Gleithülse (11) aufweist, in die jeweils ein Gleitstift (10) geführt ist, wobei sich die Bimetallfedern (4) am Träger (6) der Frontscheibe (1) bzw. am weiteren Bauteil und am Träger (3) des Displays (2) abstützen und bei Temperaturerhöhung den Träger (3) des Displays (2) gegen die Kraft jeweils einer Rückstellfeder (8) in Richtung von der Frontscheibe (1) weg verschieben.

5. Anzeigevorrichtung nach Anspruch 2, **dadurch gekennzeichnet, dass** die Mittel zur Veränderung des Abstandes zwischen dem Display (2) und der Frontscheibe (1) zumindest einen mit der Frontscheibe (1) oder mit einem mit der Frontscheibe (1) verbundenen Bauteil an seinen Enden verbundenen Bimetallstreifen (15) umfassen, der am Träger (3) des Displays (2) anliegt oder mit diesem verbunden ist, sich bei Temperaturerhöhung in Richtung auf das Display (2) wölbt und dieses gegen die Kraft jeweils zumindest einer Rückstellfeder axial in Richtung von der Frontscheibe (1) weg verschiebt, wobei bei Temperaturrückgang der Schrumpfvorgang des zumindest einen Bimetallstreifens durch die zumindest eine Rückstellfeder unterstützt wird.

6. Anzeigevorrichtung nach Anspruch 2, **dadurch gekennzeichnet, dass** als Mittel zur Veränderung des Abstandes zwischen dem Display (2) und der Frontscheibe (1) zumindest ein gewölbter Bimetallstreifen (15) vorgesehen ist, dessen ein Ende mit dem Träger (6) der Frontscheibe (1) verbunden ist und dessen anderes Ende mit dem Träger (3) des Displays (2) verbunden ist, der sich bei Temperaturerhöhung ausdehnt und das Display (2) axial in Richtung von der Frontscheibe (1) weg verschiebt.

7. Anzeigevorrichtung nach Anspruch 2, **dadurch gekennzeichnet, dass** als Mittel zur Veränderung des Abstandes zwischen dem Display (2) und der Frontscheibe (1) eine Bimetallfeder (4) oder ein gewölbter Bimetallstreifen zentral an der Rückseite des Displays (2) vorgesehen ist, wobei die Bimetallfeder (4) oder der Bimetallstreifen an dem dem Display (2) abgewandten Ende mit dem Träger (3) des Displays (2) oder mit einem mit dem Träger (3) verbundenen Bauteil verbunden ist, wobei das andere, dem Display (2) zugewandte Ende mit einem ortsfest angeordneten Bauteil (23) in der Anzeigevorrichtung verbunden ist, welches zwischen dem Display (2) und dem Träger (3) des Displays (2) oder dem mit dem Träger verbundenen Bauteil angeordnet ist, derart, dass bei Temperaturerhöhung der Abstand zwischen dem Display (2) und der Frontscheibe (1) bedingt durch die Ausdehnung der Bimetallfeder (4) oder des Bimetallstreifens erhöht wird.

8. Anzeigevorrichtung nach Anspruch 2, **dadurch gekennzeichnet, dass** als Mittel zur Veränderung des Abstandes zwischen der Frontscheibe (1) und dem Display (2) in Abhängigkeit der Temperatur zumindest ein elektrischer, pneumatischer, hydraulischer oder elektromagnetischer Aktuator vorgesehen ist, welcher in Abhängigkeit der von zumindest einem Sensor erfassten Temperatur von einer Steuerung gesteuert wird, um einen vorgegebenen Abstand zwischen dem Display (2) und der Frontscheibe (1) in Abhängigkeit der Temperatur einzustellen.

9. Anzeigevorrichtung nach Anspruch 8, **dadurch gekennzeichnet, dass** ein Näherungssensor vorgesehen ist, wobei, wenn mittels des Sensors die Anwesenheit einer Person vor der Anzeigevorrichtung detektiert wird und der Abstand zwischen dem Display (2) und der Frontscheibe (1) nicht dem Minimalwert entspricht, der zumindest eine Aktuator betätigt wird, um den Abstand zwischen der Frontscheibe (1) und dem Display (2) auf den Minimalwert zu reduzieren, so dass während der Anwesenheit der Person eine optimale Ablesbarkeit und Bedienbarkeit trotz hoher Temperaturen gewährleistet wird.

10. Anzeigevorrichtung nach einem der vorangehenden Ansprüche, **dadurch gekennzeichnet, dass** der Träger (3) des Displays (2) mittels Gleitstiften (12), die durch den Träger (6) der Frontscheibe (1) gebildet oder mit diesem verbunden sind und durch den Träger (3) des Displays (2) gebildete oder mit diesem verbundene Gleithülsen (13), in denen die Gleitstifte (12) geführt sind, gelagert ist.

11. Anzeigevorrichtung nach einem der vorangehenden Ansprüche 1-9, **dadurch gekennzeichnet, dass** der Träger (3) des Displays (2) mittels am Träger (3) drehbar gelagerter Kunststoff- oder Gummirollen (16), die in einer mit dem Träger (6) der Frontscheibe (1) verbundenen Laufschiene (17) geführt sind und jeweils eine Lagereinheit (18) bilden gelagert ist, wobei an zumindest zwei gegenüberliegenden Seiten des Displays (2) und der Frontscheibe (1) zumindest zwei Lagereinheiten (18) vorgesehen sind.

12. Anzeigevorrichtung nach einem der vorangehenden Ansprüche 1-9, **dadurch gekennzeichnet, dass** der Träger (3) des Displays (2) über eine Spindel (19), die in eine mit dem Träger (3) des Displays (2) verbundene Gewindebuchse (20) eingreift und am Träger (6) der Frontscheibe (1) über ein axial fixiertes, aber radial frei drehbares Kugellager (21) befestigt ist, gelagert ist.

13. Anzeigevorrichtung nach einem der vorangehenden Ansprüche 1-9, **dadurch gekennzeichnet, dass** der Träger (3) des Displays (2) mittels im Träger (3) des Displays (2) vorgesehener Federn (25), die in im Träger (6) der Frontscheibe (1) vorgesehenen Nuten (26) eingreifen gelagert ist.
